# EUROPEAN PATENT APPLICATION

(11) **EP 1 389 901 A1**
(43) Date of publication of application: **18.02.2004**
(21) Application number: 02726458.9
(22) Date of filing: 22.05.2002
(51) Int. Cl.: H05K 9/00, G02B 1/10, B31B 15/08

(54) **SHIELD MATERIAL AND METHOD OF MANUFACTURING THE SHIELD MATERIAL**

(30) Priority: 24.05.2001 JP 2001155747; 28.02.2002 JP 2002054810
(71) Applicant: Kyodo Printing Co., Ltd., Tokyo 112-8501 (JP)
(72) Inventor: SHIMAMURA, Masayoshi, c/o KYODO PRINTING CO., LTD., Bunkyo-ku, Tokyo 112-8501 (JP); OKAMOTO, Ryohei, c/o KYODO PRINTING CO., LTD., Bunkyo-ku, Tokyo 112-8501 (JP); ATSUCHI, Yoshiyuki, c/o KYODO PRINTING CO. LTD., Bunkyo-ku, Tokyo 112-8501 (JP)
(74) Representative: Wilding, Frances Ward
(86) International application number: PCT/JP2002/004946
(87) International publication number: WO 2002/096178

(57) **Abstract**

There are included the steps of forming a structure, in which a first adhesive layer (12), a resin layer (14), and a metal foil (16) are laminated sequentially from a bottom, on a release layer (30y) of a plastic film (30a) that has the release layer (30y) on a surface, forming metal layer patterns (16a) by patterning the metal foil (16), and forming the first adhesive layer (12), the resin layer (14), and the metal layer patterns (16a) sequentially from the bottom on a transparent substrate (10) by separating the release layer (30y) from the first adhesive layer (12) along an interface and then pasting the first adhesive layer (12) onto the transparent substrate (10).

## Description

### Technical Field

The present invention relates to a shielding base member and a method of manufacturing the same and, more particularly, a shielding base member for shielding the electromagnetic wave, etc. that leak out from the PDP (Plasma Display Panel), etc. and a method of manufacturing the same.

### Background Art

In recent years, the applications of the PDP (Plasma Display Panel), which has the wide viewing angle and the good display quality and provides the large screen, are broadened quickly into the multimedia display device, etc.

The PDP is such a display device that utilizes the gaseous discharge. The gas that is sealed in the tube is excited by using the discharge to generate the line spectrum that has the wide wavelength extending from the ultraviolet range to the near-infrared range. The fluorescent substance is arranged in the tube of the PDP. This fluorescent substance is excited by the line spectrum in the ultraviolet range to generate the light in the visible range. A part of the line spectrum in the near-infrared range is emitted from the surface glass of the PDP to the outside of the tube.

The wavelength in this near-infrared range is close to the wavelength (800 nm to 1000 nm) that is employed in the remote control unit, the optical communication, etc. If these devices are operated near the PDP, it is possible that the malfunction is caused and therefore the leakage of the near-infrared ray from the PDP must be prevented.

Also, the electromagnetic waves such as the microwave, the ultra low frequency, etc. are generated by the operation of the PDP, and then leak out to the outside although an amount of the leakage is very small. Since the provisions about the leakage of the electromagnetic wave, etc. are specified in the information device or equipment, or the like, the leakage of the electromagnetic wave must be suppressed below the specified value.

In addition, when rays of light incident upon the display screen from the outside are present, the incident light is reflected by the display screen and also the contrast ratio of the screen is lowered since the display screen of the PDP is flat. Therefore, the reflection of the incident light from the outside must be suppressed.

For the purpose of satisfying these requirements, the shielding base member is arranged in front of the display screen of the PDP.

In the related art, such shielding base member is manufactured by the method in which the plastic film to which the metal foil is adhered is pasted on the transparent glass substrate and then the metal foil is patterned, or the like. More particularly, normally a thickness of the metal foil is thin such as about 10 µm. Therefore, in order to make the handling of the metal foil easy, first the metal foil is pasted onto the plastic film. Then, in order to pattern the metal foil with good precision, the plastic film having the metal foil thereon is pasted on the glass substrate that has the strong rigidity, or the like, and then the metal foil is patterned.

However, in the shielding plate in the related art, the metal foil and the plastic film are formed integrally to make the handling of the metal foil easy. Therefore, if the shielding base member is manufactured by using this shielding plate, the plastic film still remains on the shielding base member. The plastic film has the low optical transmittance and the high haze (degree of opaque) rather than the transparent glass substrate.

Accordingly, since the plastic film still remains on the shielding base member, the optical transmittance of the shielding base member is lowered and the haze (degree of opaque) the shielding base member is increased. As a result, there is the problem such that the visibility of the screen of the PDP becomes worse by the shielding base member.

Further, In order to increase further the rigidity of the plastic film on which the metal foil is pasted, there is the shielding base member in which the metal foil is pasted onto the plastic film via the adhesive layer. In this case, in the case that the plastic film is rolled up on the roller in the manufacturing step utilizing the roll-to-roll method, etc., if the adhesive layer is pressed by the foreign matter, etc., the dent defect readily occurs in the adhesive layer because such adhesive layer is soft in itself. As a result, there is such a possibility that the quality of the shielding base member is lowered.

Besides, as the shielding base member in the related art, there is the shielding base member in which the plastic film having the near-infrared absorbing function is pasted as the near-infrared absorbing layer. Thus, the structure of such shielding base member becomes complicated and also the plastic film still remains therein. As a result, there are the problems such that the optical transmittance of the shielding base member is further lowered and the haze (degree of opaque) is further increased.

### Disclosure of the Invention

It is an object of the present invention to provide a shielding base member whose optical transmittance is high and whose a haze (degree of opaque) is low, and a method of manufacturing the same.

Also, it is another object of the present invention to provide a method of manufacturing a shielding base member having an adhesive layer that has no dent defect.

The present invention provides a shielding base member manufacturing method which comprises the steps of forming a structure, in which a first adhesive layer, a resin layer, and a metal foil are laminated sequentially from a bottom, on a release layer of a plastic film that has the release layer on a surface, forming metal layer patterns by patterning the metal foil, and forming the first adhesive layer, the resin layer, and the metal layer patterns sequentially from the bottom on a transparent substrate by separating the release layer from the first adhesive layer along an interface and then pasting the first adhesive layer onto the transparent substrate.

As described above, since the handling of the metal foil that is patterned into the metal layer patterns is not easy, the metal foil is pasted onto the plastic film via the resin layer and then the plastic film having the metal foil thereon is pasted onto the transparent substrate such as the glass substrate having the strong rigidity. As a result, the plastic film whose optical transmittance is low and whose haze (degree of opaque) is high still remains in the shielding base member.

The shielding base member manufacturing method of the present invention is invented not to leave the plastic film in the shielding base member.

More particularly, first the adhesive layer, the resin layer, and the metal foil are formed on the surface of the plastic film on which the release layer is formed. Then, the metal layer patterns are formed by patterning the metal foil in this state of the plastic film.

Since the metal foil is formed on the plastic film via the adhesive layer and the resin layer by doing the above, the plastic film has the rigidity and thus the handling of the metal foil can be facilitated. Accordingly, there is no need that the metal foil should be patterned after this plastic film is pasted onto the transparent substrate having the strong rigidity. As a result, the roll-like plastic film onto which the metal foil is pasted is extended and then the metal foil can be patterned by the so-called roll-to-roll method.

Then, the release layer formed on the plastic film is separated from the first adhesive layer along the interface, and then the first adhesive layer, the resin layer, and the metal layer patterns are pasted onto the transparent substrate such as the glass substrate having the strong rigidity.

As a result, the first adhesive layer, the resin layer, and the metal layer patterns are formed on the transparent substrate. Thus, the shielding base member in which the plastic film whose optical transmittance is low and whose haze (degree of opaque) is high is not left can be manufactured.

As described above, according to the shielding base member manufacturing method of the present invention, the patterning of the metal foil can be carried out by the roll-to-roll method and thus the production efficiency of the shielding base member can be improved. Also, since the plastic film is not left in the shielding base member, the shielding base member whose optical transmittance is high and whose haze (degree of opaque) is low can be easily manufactured.

Also, the present invention provides a shielding base member manufacturing method which comprises the steps of forming a structure, in which a first adhesive layer, a resin layer, and a metal foil are laminated sequentially from a bottom, on a release layer of a plastic film that has the release layer on a surface, forming the first adhesive layer, the resin layer, and the metal foil sequentially from the bottom on a transparent substrate by separating the release layer from the first adhesive layer along an interface and then pasting the first adhesive layer onto the transparent substrate, and forming metal layer patterns by patterning the metal foil.

According to the present invention, first the first adhesive layer, the resin layer, and the metal layer are formed on the plastic film via the release layer, then the release layer is separated from the first adhesive layer along the interface, and then the first adhesive layer, the resin layer, and the metal layer are pasted onto the transparent substrate. Then, the metal layer patterns are formed by patterning the metal layer on the transparent substrate.

According to the above shielding base member manufacturing method, the metal layer patterns are formed by patterning the metal foil, which is formed over the plastic film, by virtue of the roll-to-roll method. In contrast, according to the present invention, the first adhesive layer, the resin layer, and the metal layer are transferred onto the transparent substrate, and then the metal layer is patterned.

The shielding base member manufactured by such manufacturing method can achieve the similar effects as the above shielding base member. Also, if the substrate having the strong rigidity such as the glass substrate, for example, is employed as the transparent substrate, the finer metal layer patterns can be formed stably and also the margin of design of the shielding base member can be improved.

Also, the present invention provides a shielding base member manufacturing method which comprises the steps of_preparing a first plastic film including a first adhesive layer, a resin layer, and a metal foil sequentially from a bottom on a surface, forming metal layer patterns by patterning the metal foil, forming the resin layer and the metal layer patterns on a second adhesive layer of a second plastic film, which has a release layer and the second adhesive layer sequentially from the bottom on a surface, by separating the first adhesive layer from the resin layer along an interface and then pasting a surface of the second adhesive layer of the second plastic film onto a surface of the resin layer, and forming the second adhesive layer, the resin layer, and the metal layer patterns sequentially from the bottom on a transparent substrate by separating the release layer from the second adhesive layer along an interface and then pasting a surface of the second adhesive layer onto the transparent substrate.

In the present invention, first the first plastic film that has the first adhesive layer, the resin layer, and the metal foil sequentially from the bottom on its surface is prepared, and then the metal layer patterns are formed by patterning the metal foil. At this time, since the roll-to-roll method is employed for the purpose of improving the production efficiency, the dent defect is easily generated in the first adhesive layer by the foreign matter, or the like when the first plastic film is wound on the roll. Then, the first transfer body consisting of the resin layer and the metal layer patterns formed thereon is obtained by separating the first adhesive layer of the first plastic film from the resin layer along the interface. Accordingly, the first plastic film having the first adhesive layer in which the dent defect is generated is abandoned.

Then, the second plastic film having the release layer and the second adhesive layer sequentially from the bottom is prepared. Then, the exposed surface of the second adhesive layer is pasted onto the surface of the resin layer, on which the metal layer patterns are not formed, in the first transfer body. Accordingly, the resin layer and the metal layer patterns are formed on the second adhesive layer of the second plastic film. That is, the new second adhesive layer in which the dent defect is not generated is formed under the resin layer in place of the first adhesive layer in which the dent defect is generated.

Then, the second transfer body consisting of the second adhesive layer, the resin layer, and the metal layer patterns sequentially from the bottom is obtained by separating the second adhesive layer from the resin layer along the interface. Then, the exposed surface of the second adhesive layer of this second transfer body is pasted onto one surface of the glass substrate. Thus, the shielding base member in which the second adhesive layer that contains no dent defect, the resin layer, and the metal layer patterns are formed sequentially from the bottom on the transparent substrate is manufactured.

As described above, according to the shielding base member manufacturing method according to the present embodiment, since the plastic film does not remain in the shielding base member; the shielding base member whose optical transmittance is high and whose haze (degree of opaque) is low can be easily manufactured. Also, since the metal foil is formed on the first plastic film having the first adhesive layer and the strong rigidity, such metal foil can be patterned by the roll-to-roll method while expanding the plastic film, and thus the production efficiency can be improved.

In addition, even if the dent defect occurs in the first adhesive layer at this time, the first adhesive layer can be replaced with the new second adhesive layer in later steps. Since the roll-to-roll method is not needed in the step after the second adhesive layer is formed, the shielding base member can be manufactured not to wind the second adhesive layer on the roll. Therefore, no dent defect exists in the second adhesive layer of the shielding base member, and thus the shielding base member of the high quality can be manufactured in high yield.

Also, the present invention provides a shielding base member manufacturing method which comprises the steps of preparing a first plastic film including a first adhesive layer, a resin layer, and a metal foil sequentially from a bottom on a surface, forming metal layer patterns by patterning the metal foil, forming the resin layer and the metal layer patterns on a second adhesive layer of a second plastic film, which has a release layer and the second adhesive layer sequentially from the bottom on a surface, by separating the first adhesive layer from the resin layer along an interface and then pasting a surface of the second adhesive layer of the second plastic film onto a surface of the resin layer, and getting a shielding base member including of the second adhesive layer, the resin layer, and the metal layer patterns by separating the release layer from the second adhesive layer along an interface.

In the present invention, unlike the above shielding base member manufacturing methods, the shielding base member is not formed by pasting the second transfer body (the second adhesive layer, the resin layer, and the metal layer patterns) onto the transparent substrate, but the member consisting of the second adhesive layer, the resin layer, and the metal layer patterns is selected as the shielding base member and then the exposed surface of the second adhesive layer of this shielding base member is pasted directly onto the display screen of the PDP.

In this manner, since the plastic film is hot left in the shielding base member, the shielding base member whose optical transmittance is high and whose haze (degree of opaque) is low can be easily manufactured. Also, since the dent defect does not remain in the second adhesive layer of the shielding base member, the shielding base member of the high quality can be manufactured.

Also, the present invention provides a shielding base member which comprises a transparent substrate, a first adhesive layer formed on the transparent substrate; a resin layer formed on the first adhesive layer, metal layer patterns formed on the resin layer, and a reflection preventing layer formed on the metal layer patterns and the resin layer via a third adhesive layer.

The shielding base member of the present invention is the shielding base member manufactured by the above shielding base member manufacturing methods, for example. Since this shielding base member does not contains the plastic film whose optical transmittance is low and whose haze (degree of opaque) is high, the visibility of the PDP can be improved when such shielding base member is employed as the shielding base member of the PDP.

Also, the present invention provides a shielding base member which comprises a transparent substrate; a first adhesive layer formed on the transparent substrate; a resin layer formed on the first adhesive layer and having at least a near-infrared absorbing function; metal layer patterns formed on the resin layer; and a filter layer formed on the metal layer patterns and the resin layer via a second adhesive layer and having at least a reflection preventing function.

According to the shielding base member of the present invention, the plastic film employed as the substrate that make it easy to handle the metal foil does not remain in the shielding base member, and also the near-infrared absorbing function is provided by including the pigment material that absorbs the predetermined wavelength of the near-infrared ray in the resin layer, or the like. Therefore, unlike the related art, there is no necessity that the plastic film having the near-infrared absorbing function should be formed separately.

In this manner, the plastic film as the substrate of the metal foil or the near-infrared absorbing layer is removed. Therefore, the optical transmittance can be increased much more and the haze (degree of opaque) can be reduced much more, and thus the display characteristic of the PDP can be improved much more.

### Brief Description of the Drawing

FIG.1A to FIG.1D are schematic sectional views showing a first manufacturing method of a shielding base member according to a first embodiment of the present invention;
FIG.2A to FIG.2D are schematic sectional views showing a second manufacturing method of a shielding base member according to the first embodiment of the present invention;
FIG.3A is a schematic sectional view showing the shielding base member according to the first embodiment of the present invention, and FIG.3B is a schematic sectional view showing a variation of the shielding base member according to the first embodiment of the present invention;
FIG.4 is a schematic sectional view showing a shielding base member according to a second embodiment of the present invention;
FIG.5 is a schematic sectional view showing a shielding base member according to a third embodiment of the present invention;
FIG.6 is a schematic sectional view showing a shielding base member according to a fourth embodiment of the present invention;
FIG.7 is a schematic sectional view showing a shielding base member according to a fifth embodiment of the present invention;
FIG.8A is a schematic sectional view showing a shielding base member according to a sixth embodiment of the present invention, and FIG.8B is a schematic sectional view showing a variation of the shielding base member according to the sixth embodiment of the present invention;
FIG.9A to FIG.9G are schematic sectional views showing a shielding base member manufacturing method according to a seventh embodiment of the present invention;
FIG.10A to FIG.10C are schematic sectional views showing a shielding base member manufacturing method according to an eighth embodiment of the present invention;
FIG.11 'is a schematic sectional view showing a shielding base member according to the eighth embodiment of the present invention;
FIG.12 is a schematic sectional view showing a shielding base member according to a ninth embodiment of the present invention; and
FIG.13 is a schematic sectional view showing a variation of the shielding base member according to the ninth embodiment of the present invention.

### Best Modes For Carrying Out the Invention

Embodiments of the present invention will be explained with reference to the drawings hereinafter.

### (First Embodiment)

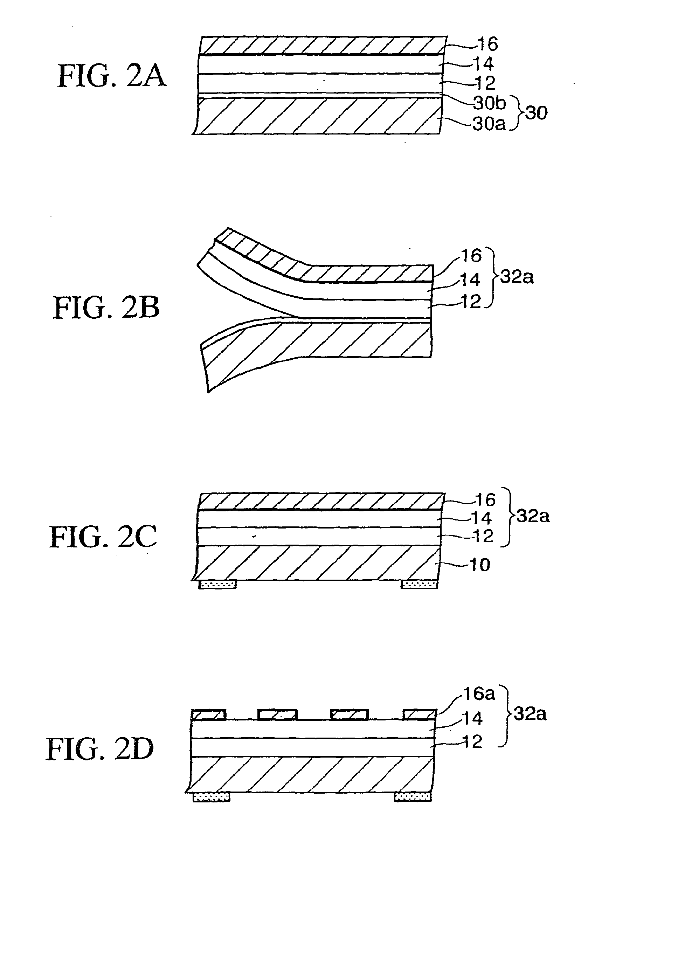

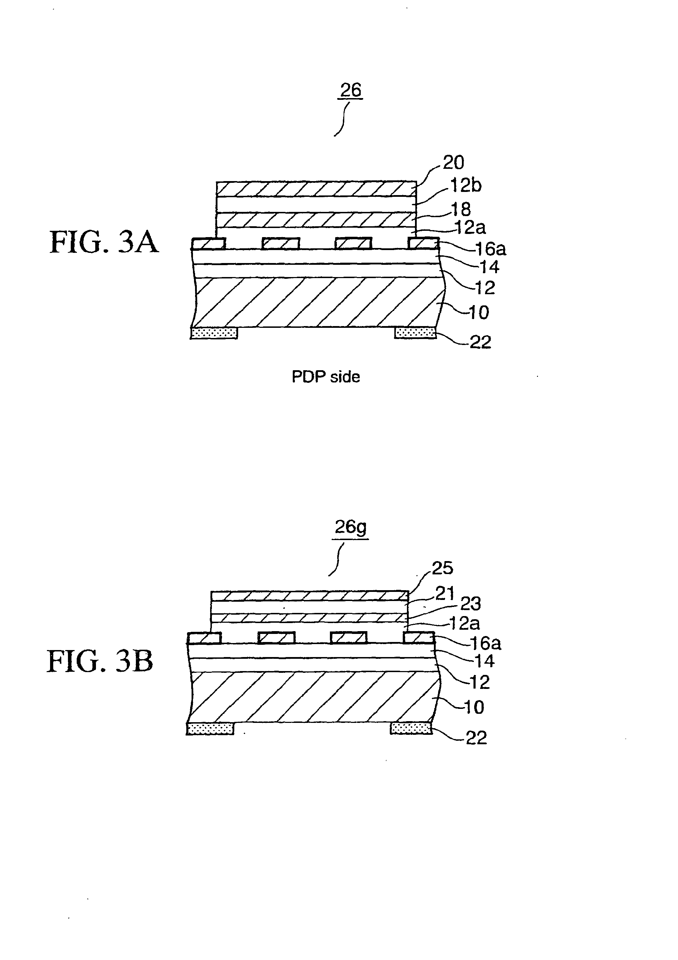

FIG.1A to FIG.1D are schematic sectional views showing a first manufacturing method of a shielding base member according to a first embodiment of the present invention, and FIG.2A to FIG.2D are schematic sectional views showing a second manufacturing method'of a shielding base member according to the first embodiment of the present invention. FIG.3A is a schematic sectional view showing the shielding base member according to the first embodiment of the present invention, and FIG.3B is a schematic sectional view showing a variation of the shielding base member according to the first embodiment of the present invention.

First of all, manufacturing methods of the shielding base member according to the first embodiment of the present invention will be explained hereunder.

### (First manufacturing method of the shielding base member)

First, as shown in FIG.1A, a PET (polyethylene terephthalate) film 30a as an example of the plastic film is prepared. A silicone layer 30b (release layer) of 1 µ m, for example, is coated on one surface of this PET film 30a.

The method of forming the silicone layer 30b is given as follows. First, a process solution of 600 wt% in total is formed by mixing the silicone (KS-3703 manufactured by Shin-Etsu Chemical Co., Ltd.) of 100 wt%, the catalyst (CAT-PL-50T) of 1 wt%, and the solvent (toluene) of 499 wt%. Then, the silicone layer 30b is formed by coating this process solution on the PET film 30a by the bar coater, and then executing the annealing at 120 °C for 30 seconds. This plastic film 30a on one surface of which the silicone layer 30b is formed is called a separator 30 hereinafter.

Then, a first adhesive layer 12 having a thickness of 10 to 50 µm, preferably 25 µm, for example, is formed on the surface of the separator 30, on which the silicone layer 30b is formed.

Then, a copper foil 16 (metal foil) of 10 µm thickness, for example, is prepared. The blackening process is applied to the bright surface of this copper foil 16 by immersing the copper foil 16 in a mixed solution consisting of a copper pyrophosphate aqueous solution, a potassium pyrophosphate aqueous solution, and an ammonia aqueous solution, for example, and then executing the electrolytic plating at the current density of 5A/cm² for 10 second.

Then, a resin layer 14 is formed on the first adhesive layer 12. Then, the copper foil 16 is arranged on the resin layer 14 such that the blackened surface of the copper foil 16 opposes to the resin layer 14 side, and then is pasted onto the resin layer 14 by baking them at 80 °C for 20 second and pressurizing them under the condition of 5 kg/cm², for example.

Accordingly, a structure in which the first adhesive layer 12, the resin layer 14, and the copper foil 16 are laminated on the separator 30 sequentially from the bottom is formed. Since not only the resin layer 14 but also the first adhesive layer 12 is formed between the separator 30 and the copper foil 16, the rigidity of the separator 30 can be enhanced.

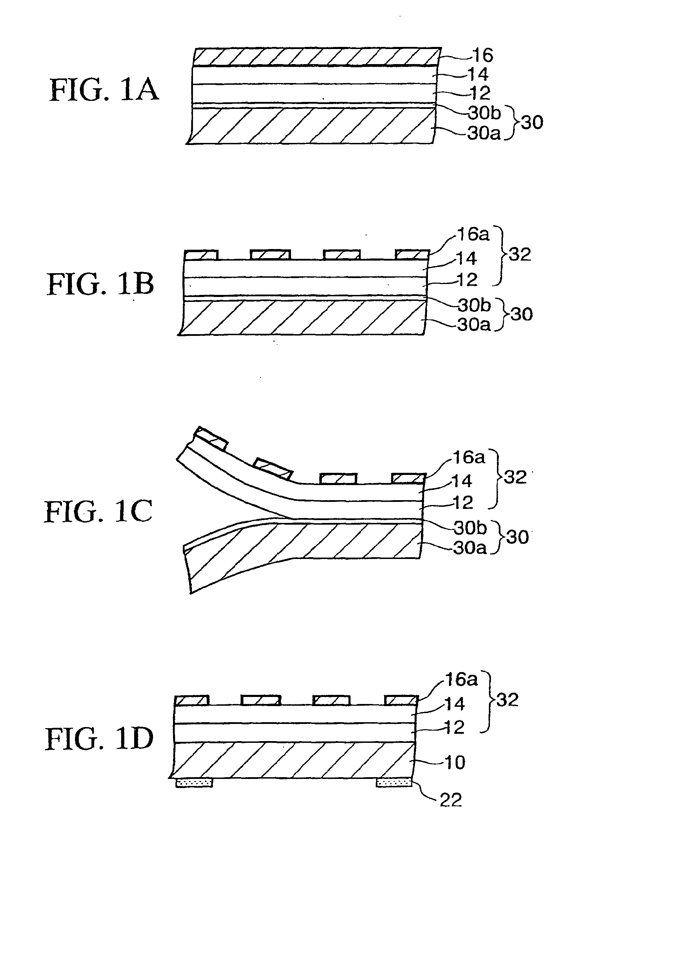

Then, as shown in FIG.1B, the resist film (not shown) is formed on the copper foil 16 by the roll-to-roll method and then the copper foil 16 is etched by spraying an iron (III) chloride aqueous solution, for example, upon this copper foil 16 while using this resist film as a mask. Thus, copper layer patterns 16a (patterns of the metal layer) are formed like a mesh, for example.

At this time, since the first adhesive layer 12 is present between the separator 30 and the copper foil 16 and thus the rigidity is enhanced rather than the case that the first adhesive layer 12 is not provided, the separator 30 can stand the pressure of the sprayed etchant and the copper foil 16 can be etched stably. Also, in the case of the structure in which the first adhesive layer 12 is exposed after the copper foil 16 is etched, i.e., in the case of the structure in which the resin layer 14 is not present, the color of the first adhesive layer 12 is changed from the transparency to the yellow color by the etchant. However, in the present embodiment, since the cured resin layer 14 is present on the first adhesive layer 12, such disadvantage is not caused and thus the transparency of the first adhesive layer 12 can be maintained.

Then, the blackening process is applied to the exposed surface of the copper layer patterns 16a by executing the transforming process of the copper layer patterns 16a by using a mixed solution consisting of a chlorite soda aqueous solution and a caustic soda aqueous solution. Since the surface of the copper foil 16 on the resin layer 14 side is blackened in the above step, both surfaces and side surfaces of all copper layer patterns 16a are blackened at a point of time when this step is finished.

In this manner, as shown in FIG.1B, a transfer body 32 consisting of the first adhesive layer 12, the resin layer 14, and the copper layer patterns 16a is formed on the separator 30.

Then, as shown in FIG.1C, the separator 30 and the first adhesive layer 12 are separated along their interface. At this time, since the adhesion strength between the silicone layer 30b and the first adhesive layer 12 is weakened rather than that between the silicone layer 30b and the PET film 30a, the transfer body 32 can be easily separated along the interface between the separator 30 and the first adhesive layer 12.

Then, as shown in FIG.1D, a transparent glass substrate 10 (transparent substrate), on a peripheral portion of one surface of which a black frame layer 22 is formed, is prepared. In turn, the exposed surface of the first adhesive layer 12 is pasted onto the surface of the glass substrate 10, on which the black frame layer 22 is not formed. Accordingly, the transfer body 32 that consists of the first adhesive layer 12, the resin layer 14, and the copper layer patterns 16a in sequence from the bottom is formed on the glass substrate 10.

Then, as shown in FIG.3A, a second adhesive layer 12a having a color correcting function is formed on the copper layer patterns 16a and the resin layer 14 such that the copper layer patterns 16a on the peripheral portion are exposed. Then, a near-infrared absorbing layer 18 is formed on this second adhesive layer 12a.

Then, a third adhesive layer 12b having a ultraviolet (UV) absorbing function is formed on the near-infrared absorbing layer 18. And then a PET reflection preventing layer 20 having a reflection preventing function is formed on the third adhesive layer 12b by using a PET film that a reflection preventing layer is formed on a one surface thereof, or the like.

With the above, a shielding base member 26 manufactured by the first manufacturing method of the shielding base member according to the present embodiment is completed.

### (Second manufacturing method of the shielding base member)

The difference of the second manufacturing method from the first manufacturing method is that metal patterns are formed by patterning a metal layer after the metal layer, etc. are transferred onto the glass substrate. Therefore, in FIG.2A to FIG.2D, the same symbols are affixed to the same elements as those in FIG.1A to FIG.1D, and their detailed explanation will be omitted herein.

First, as shown in FIG.2A, in the same manner as the first manufacturing method, a structure in which the first adhesive layer 12, the resin layer 14, and the copper foil 16, the surface of which on the resin layer 14 side is subjected to the blackening process, are formed on the separator 30 is formed.

Then, as shown in FIGS.2B and 2C, in the same manner as the first manufacturing method, the silicone layer 30b and the first adhesive layer 12 are separated along their interface, and then the first adhesive layer 12 is pasted onto the surface of the glass substrate 10, on which the black frame layer is not formed. Thus, a transfer body 32a that consists of the first adhesive layer 12, the resin layer 14, and the copper foil 16 in sequence from the bottom is formed on the glass substrate 10.

Then, as shown in FIG.2D, the copper layer patterns 16a are formed by patterning the resist film (not shown) on the copper foil 16 and etching the copper foil 16 by the iron (III) chloride aqueous solution, for example, while using this resist film as a mask.

In the second manufacturing method, the first adhesive layer 12, the resin layer 14, and the copper foil 16 are transferred onto the glass substrate 10, and then the copper layer patterns 16a are formed by patterning the copper foil 16. Since the copper foil is patterned in the state of the glass substrate that has the very strong rigidity, the patterning precision of the resist film is increased and therefore the finer copper layer patterns can be formed stably.

Then, the blackening process of surfaces of side surfaces of the copper layer patterns 16a is executed by the same method as the first manufacturing method.

Accordingly, as shown in FIG.2D, the structure similar to that in FIG.1D is formed, i.e., the first adhesive layer 12, the resin layer 14, and the copper layer patterns 16a are formed sequentially from the bottom on the glass substrate.

Then, as shown in FIG.3A, the near-infrared absorbing layer 18 is formed on the copper layer patterns 16a and the resin layer 14 via the second adhesive layer 12a having the color correcting function by the same method as the first manufacturing method. Then, the PET reflection preventing layer 20 is formed on the near-infrared absorbing layer 18 via the third adhesive layer 12b having the ultraviolet (UV) absorbing function.

With the above, the shielding base member 26 manufactured by the second manufacturing method of the shielding base member according to the present embodiment is completed.

In the shielding base member 26 of the present embodiment, as shown in FIG.3A, the mesh-like copper layer patterns 16a, for example, are formed on one surface of the glass substrate 10 via the first adhesive layer 12 and the resin layer 14. Both surfaces of the side surfaces, i.e., all surfaces of the copper layer patterns 16a are subjected to the blackening process to eliminate the metal luster and exhibit the blackish color.

Then, the near-infrared absorbing layer 18 is formed on the copper layer patterns 16a and the resin layer 14 via the second adhesive layer 12a, and then the PET reflection preventing layer 20 is formed on the near-infrared absorbing layer 18 via the third adhesive layer 12b. The ultraviolet (UV) absorber is added into the third adhesive layer 12b being formed directly under the PET reflection preventing layer 20, and thus the third adhesive layer 12b has the ultraviolet (UV) absorbing function. Also, for example, the second adhesive layer 12a has the color correcting function. In this case, at least one adhesive layer out of first, second, and third adhesive layers 12, 12a, 12b may be formed to have the color correcting function.

The second adhesive layer 12a, the near-infrared absorbing layer 18, the third adhesive layer 12b, and the PET reflection preventing layer 20 are formed to expose the copper layer patterns 16a on the peripheral portion. The copper layer patterns 16a formed on the peripheral portion of the glass substrate 10 is connected to the ground circuit of the PDP to prevent the charging.

The black frame layer 22 is formed on the peripheral portion of the other surface of the glass substrate 10. In this case, the black frame layer 22 may be formed on the peripheral portion of one surface of the glass substrate 10, i.e., on the peripheral portion of the glass substrate 10 on the first adhesive layer 12 side. Otherwise, the black frame layer 22 may be omitted.

The shielding base member 26 of the present embodiment has the above structure. The shielding base member 26 is arranged in the PDP such that the copper layer patterns 16a formed on the peripheral portion of the glass substrate 10 are connected electrically to the ground terminal of the casing of the PDP, the surface of the glass substrate 10 on the black frame layer 22 side is directed to the display screen side of the PDP, and the surface of the glass substrate 10 on the first adhesive layer 12 side is directed to the operator side of the PDP. Since the copper layer patterns 16a are the good conductor, the electromagnetic waves such as the micro wave, the ultra low frequency wave, etc. being emitted from the display screen of the PDP can be shielded.

The manufacturing method of the shielding base member 26 of the present embodiment is invented not to leave the PET film 30a, whose optical transmittance is low and whose haze (degree of opaque) is high, in the shielding base member 26. In other words, the manufacturing method of the shielding base member 26 of the present embodiment has such a feature that the separator 30, in which the release layer made of the silicone layer 30b is formed on the PET film 30a, is employed such that the PET film 30a can be easily separated from the transfer body 32 or 32a that consists of the first adhesive layer 12, the resin layer 14, and the copper layer patterns 16a or the copper foil 16 being formed on the PET film 30a.

More particularly, in the first manufacturing method, first the rigidity of the separator 30 is increased by pasting the copper foil 16, which is not easily handled, onto the separator 30 via the first adhesive layer 12 and the resin layer 14, and then the copper layer patterns 16a are formed by etching the copper foil in the state that the roll-like separator 30 is pulled out.

Then, since the silicone layer 30b is formed at the interface between the separator 30 and the first adhesive layer 12, the separator 30 can be easily separated from the first adhesive layer 12 along this interface. Therefore, the transfer body 32 that consists of the first adhesive layer 12, the resin layer 14, and the copper layer patterns 16a can be pasted onto the glass substrate 10.

If doing this, the copper foil 16 can be patterned in the state of the roll-like separator 30 by the so-called roll-to-roll method and thus the production efficiency can be improved. In addition, the transfer body 32 in which the PET film 30a does not remain can be formed by transferring onto the glass substrate 10 after the transfer body 32 is separated from the separator 30.

In the second manufacturing method, after the first adhesive layer 12, the resin layer 14, and the copper foil 16 are transferred onto the glass substrate 10, the copper layer patterns 16a are formed by patterning the copper foil 16. Also, in this second manufacturing method, the shielding base member in which the PET film 30a does not remain can be easily manufactured.

In this manner, the shielding base member 26 of the present embodiment is constructed not to contain the PET film other than the PET reflection preventing layer 20. Therefore, the optical transmittance of the shielding base member can be increased and also the haze (degree of opaque) can be lowered.

Also, the shielding base member 26 of the present embodiment has the PET reflection preventing layer 20 and can suppress the reflection of light being input from the outside. Therefore, the electromagnetic wave can be shielded and also the contrast ratio of the display screen of the PDP can be improved. In addition, since the PET reflection preventing layer 20 is formed of the PET film, the adhesiveness between the PET reflection preventing layer 20 and the third adhesive layer 12b can be improved.

In addition, since the shielding base member 26 of the present embodiment has the near-infrared absorbing function, there is no possibility that the malfunction is caused even if the remote control unit, or the like is operated near the PDP.

Further, since the shielding base member 26 of the present embodiment has the ultraviolet (UV) absorbing function, the ultraviolet ray that is harmful to the human body can be shielded. Furthermore, since the shielding base member 26 of the present embodiment has the color correcting function, the luminous intensity in the concerned color can be corrected even if the light emission in some color in the PDP is enhanced. For example, because the mixed gas consisting of a xenon and a neon is employed in the color PDP to generate the discharging, the light emission in orange color of the neon acts as one factor to lower the color display performance of the PDP. Therefore, in the shielding base member 26 of the present embodiment, the color correction of the color display in the PDP can be achieved by forming the shielding base member to contain the pigment of the color, which can suppress the light emission of the neon, for example, in the adhesive layer, or the like.

Next, a variation of the manufacturing method of the shielding base member according to the present embodiment will be explained hereunder.

First, the structure shown in FIG.1D is manufactured by the first manufacturing method of the shielding base member, or the structure shown in FIG.2D is manufactured by the second manufacturing method of the shielding base member.

Then, as shown in FIG.3B, a PET film 21 is prepared, and then a reflection preventing layer 25 is formed on one surface of this PET film 21 and also a near-infrared absorbing layer 23 is formed on the other surface of this PET film 21. That is, the plastic film 21 that has the reflection preventing function on one surface and has the near-infrared absorbing function on the other surface must be prepared.

Then, as shown in FIG.3B similarly, the second adhesive layer 12a is formed on the copper layer patterns 16a and the resin layer 14. Then, the surface of the PET film 21 on the near-infrared absorbing layer 23 side is pasted onto the glass substrate 10 via this second adhesive layer 12a. Accordingly, as shown in FIG.3B similarly, the PET film 21 on one surface of which the near-infrared absorbing layer 23 is formed and on the other surface of which the reflection preventing layer 25 is formed in place of the near-infrared absorbing layer 18, the third adhesive layer 12b, and the PET reflection preventing layer 20, which are formed on the second adhesive layer 12a in FIG.3A, can be pasted onto the second adhesive layer 12a. As a result, the shielding base member 26g according to the variation of the present embodiment is completed.

In the shielding base member 26g according to the variation of the present embodiment, the shielding base member having the substantially same functions as the above shielding base member can be obtained and thus the similar effects can be achieved. Also, since the PET film having the near-infrared absorbing function and the reflection preventing function is pasted onto the glass substrate having the copper layer patterns, the manufacture of the shielding base member 26g can be facilitated in contrast to the shielding base member 26 and also the structure thereof can be simplified.

### (Second Embodiment)

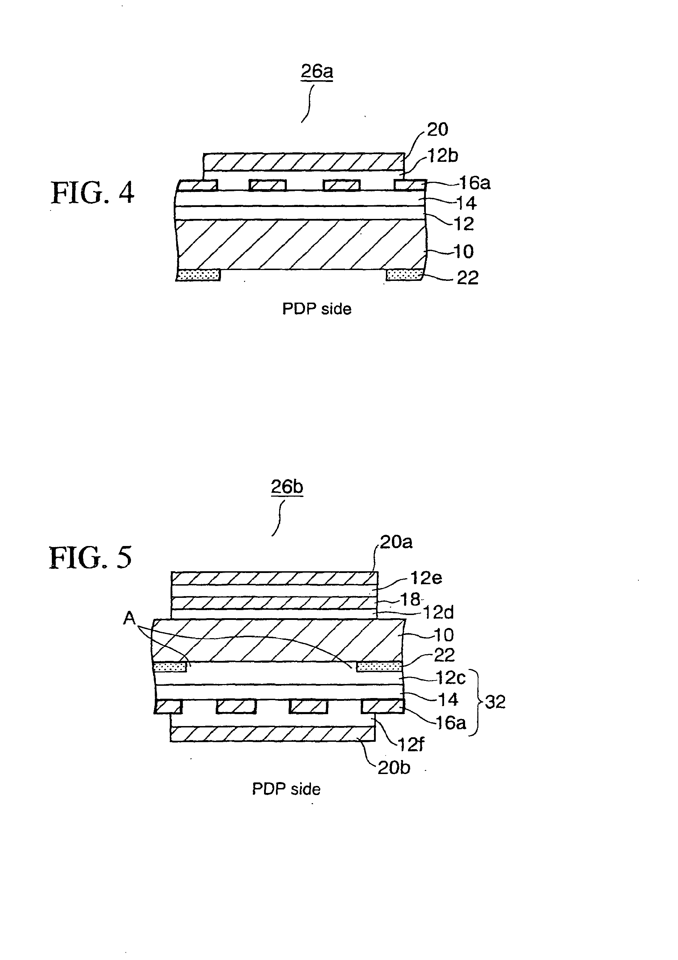

FIG.4 is a schematic sectional view showing a shielding base member according to a second embodiment of the present invention. The difference of the shielding base member of the second embodiment from the shielding base member of the first embodiment resides in that the near-infrared absorbing layer is not formed and such function is given to the adhesive layer. Therefore, in FIG.4, the same symbols are affixed to the same elements as those in FIG.3A, and their detailed explanation will be omitted herein.

As shown in FIG.4, the shielding base member 26a of the second embodiment has a structure in which the near-infrared absorbing layer is not particularly formed. The copper layer patterns 16a are formed on the glass substrate 10 via the first adhesive layer 12 and the resin layer 14, and then the PET reflection preventing layer 20 is formed on the copper layer patterns 16a via the third adhesive layer 12b having the near-infrared absorbing function. In this manner, since the third adhesive layer 12b has the near- infrared absorbing function, there is no necessity that the near-infrared absorbing layer should be particularly formed.

Also, at least one of the first adhesive layer 12 and the third adhesive layer 12b has the ultraviolet (UV) absorbing function. In addition, at least one of the first adhesive layer 12 and the third adhesive layer 12b has the color correcting function.

In this case, the near-infrared absorbing function may be provided to the first adhesive layer 12 in place of the third adhesive layer 12b, otherwise both layers may have the near-infrared absorbing function. Also, the black frame layer 22 may be omitted.

The shielding base member 26a of the present embodiment can be manufactured by the same manufacturing method as the shielding base member of the first embodiment.

According to the shielding base member 26a of the present embodiment, the similar effects to the shielding base member 26 of the first embodiment can be achieved. Also, since there is no necessity that the near-infrared absorbing layer should be particularly formed, the manufacture of the shielding base member of the present embodiment can be facilitated. In addition, since the near-infrared absorbing layer is not present and the optical transmittance can be improved accordingly, the visibility of the PDP can be improved rather than the shielding base member 26 of the first embodiment.

### (Third Embodiment)

FIG.5 is a schematic sectional view showing a shielding base member according to a third embodiment of the present invention. The difference of the shielding base member of the third embodiment from the shielding base member of the first embodiment resides in that the metal layer patterns of the shielding base member are formed on the surface of the transparent substrate on the PDP side and the reflection preventing layer is formed on both surfaces of the transparent substrate. Therefore, in FIG.5, the same symbols are affixed to the same elements as those in FIG.3A, and their detailed explanation will be omitted herein.

As shown in FIG.5, in the shielding base member 26b of the third embodiment, the black frame layer 22 is formed on one surface of the glass substrate 10, i.e., the surface on the PDP side, and the copper layer patterns 16a are formed on the black frame layer 22 and the glass substrate 10 via a first adhesive layer 12c and the resin layer 14.

In contrast, the near-infrared absorbing layer 18 is formed on the other surface of the glass substrate 10 via a second adhesive layer 12d, and also a first PET reflection preventing layer 20a is formed on this near-infrared absorbing layer 18 via a third adhesive layer 12e. Then, a second PET reflection preventing layer 20b is formed on the copper layer patterns 16a via a fourth adhesive layer 12f.

In this case, the near-infrared absorbing layer 18 may be formed between a fourth adhesive layer 12f and the second PET reflection preventing layer 20b, and the second PET reflection preventing layer 20b may be formed on the near- infrared absorbing layer 18 via the second adhesive layer 12d. Also, instead of the provision of the near-infrared absorbing layer 18 and the second adhesive layer 12d, the near-infrared absorbing layer may be coated on the surface of the second PET reflection preventing layer 20b on the PDP side.

In the shielding base member 26b of the third embodiment, the first PET reflection preventing layer 20a is formed on the surface of the glass substrate 10 on the PDP operator side, and the second PET reflection preventing layer 20b is formed on the surface of the glass substrate 10 on the PDP side. Both the first PET reflection preventing layer 20a and the second PET reflection preventing layer 20b do not have the ultraviolet (UV) absorbing function. Alternatively, at least one adhesive layer of the first, second, third, and fourth adhesive layers 12c, 12d, 12e, 12f has the ultraviolet (UV) absorbing function. It is preferable that the third adhesive layer 12e should have the ultraviolet (UV) absorbing function.

Also, at least one adhesive layer of the first, second, third, and fourth adhesive layers 12c, 12d, 12e, 12f has the color correcting function. It is preferable that the second adhesive layer 12d should have the color correcting function. In addition, the black frame layer 22 may be omitted.

According to the shielding base member 26b of the third embodiment, the similar effects to the shielding base member of the first embodiment can be achieved. Also, since the first PET reflection preventing layer 20a and the second PET reflection preventing layer 20b are formed on the surfaces of the shielding base member on the PDP operator side and the PDP side respectively, the reflection of the light irradiated from the outside and the reflection of the light emitted from the display screen of the PDP can be suppressed without fail and thus the contrast ratio of the display screen of the PDP can be improved.

Also, the shielding base member 26b of the present embodiment is constructed such that the copper layer patterns 16a are formed on the surface of the glass substrate 10, on which the black frame layer 22 is formed, via the first adhesive layer 12c and the resin layer 14. Here, assuming the case where the PET film 30a still remains between the first adhesive layer 12c and the resin layer 14. In this case, since the PET film 30a has the rigidity to some extent, the first adhesive layer 12c is pulled toward the PET film 30a side not to enter into stepped portions (A portions in FIG.5) at pattern edges of the black frame layer 22, and thus the bubbles are ready to generate in these stepped portions. Accordingly, lines due to the bubbles are generated along the pattern edges of the black frame layer 22, and thus it is possible that the high-class sense of the PDP is damaged and the visibility is deteriorated.

However, according to the present embodiment, since the PET film 30a is not present, the first adhesive layer 12c can be formed to follow the stepped portions (A portions in FIG.5) at the pattern edges of the black frame layer 22 and to bury the stepped portions. As a result, the lines due to the bubbles are not generated along the pattern edges of the black frame layer 22, and thus the event that the high-class sense of the PDP is damaged and the visibility is deteriorated can be prevented.

Next, the manufacturing method of the shielding base member 26b of the present embodiment will be explained hereunder.

First, in the same way as the first manufacturing method of the first embodiment, the transfer body 32 consisting of the first adhesive layer 12c, the resin layer 14, and the copper layer patterns 16a, which are formed on the separator 30, is separated from the separator 30 and then pasted onto one surface of the glass substrate 10, on which the black frame layer 22 is formed. At this time, as described above, because the PET film is not provided to the transfer body 32, the transfer body 32 can be pasted onto the glass substrate 10 such that the first adhesive layer 12c follows the stepped portions A of the black frame layer 22 and is buried in the stepped portions A.

Otherwise, in the same way as the second manufacturing method of the first embodiment, the transfer body 32a consisting of the first adhesive layer 12c, the resin layer 14, and the copper foil 16, which are formed on the separator 30, is separated from the separator 30 and then pasted onto one surface of the glass substrate 10, on which the black frame layer 22 is formed.

Then, if the second manufacturing method is employed, the copper layer patterns 16a are formed by patterning the copper foil 16 over the glass substrate 10.

Then, the second PET reflection preventing layer 20b is formed on the copper layer patterns 16a and the resin layer 14 via the fourth adhesive layer 12f.

Then, the near-infrared absorbing layer 18 is formed on the other surface of the glass substrate 10 via the second adhesive layer 12d, and then the first PET reflection preventing layer 20a is formed on the near-infrared absorbing layer 18 via the third adhesive layer 12e.

With the above, the shielding base member 26b of the third embodiment is completed.

### (Fourth Embodiment)

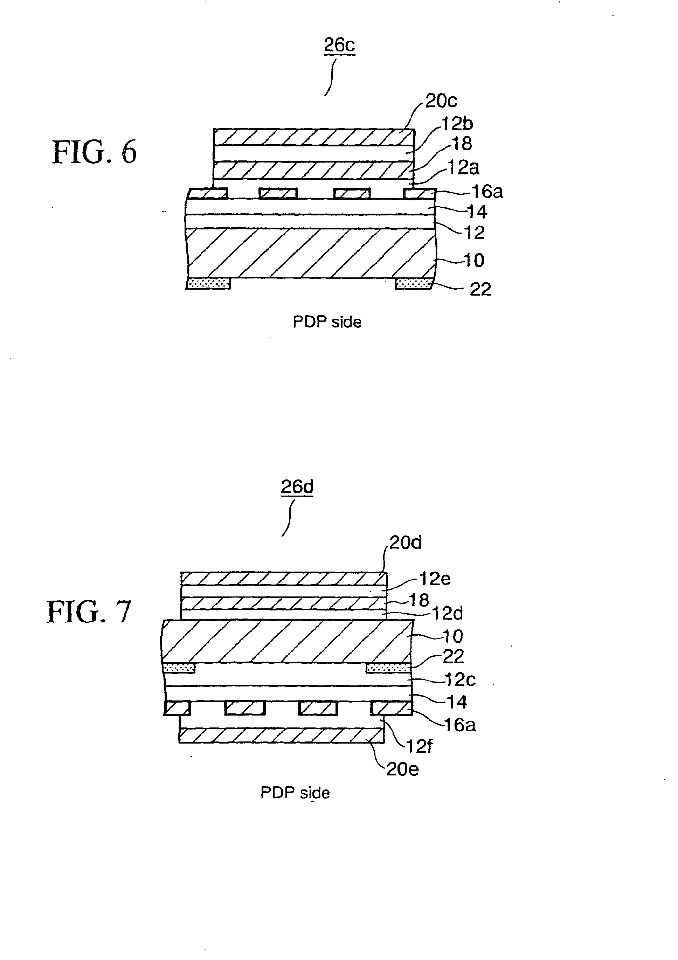

FIG.6 is a schematic sectional view showing a shielding base member according to a fourth embodiment of the present invention. The shielding base member of the fourth embodiment is formed by replacing the material of the reflection preventing layer in the shielding base member of the first embodiment. Therefore, in FIG.6, the same symbols are affixed to the same elements as those in FIG.3A, and their detailed explanation will be omitted herein.

The difference of the shielding base member 26c of the present embodiment from the shielding base member 26 of the first embodiment is that, as shown in FIG.6, a TAG (triacetylcellulose) film is employed in place of the PET film as a reflection preventing layer 20c. Since this TAC reflection preventing layer 20c has the ultraviolet (UV) absorbing function, there is no necessity that the third adhesive layer 12b, for example, should have the ultraviolet (UV) absorbing function.

Also, like the shielding base member 26 of the first embodiment, at least one adhesive layer of the first, second, and third adhesive layers 12, 12a, 12b has the color correcting function. In this case, the black frame layer 22 may be omitted herein. Also, like the variation of the shielding base member of the first embodiment, the TAC film having the reflection preventing layer on one surface and the near-infrared absorbing layer on the other surface may be prepared instead of the near-infrared absorbing layer 18, the third adhesive layer 12b, and the TAC reflection preventing layer 20c, and then the surface of the near-infrared absorbing layer of this TAG film may be pasted onto the second adhesive layer 12a over the glass substrate 10.

According to the shielding base member 26c of the present embodiment, since the TAG reflection preventing layer 20c is employed as the reflection preventing layer, the optical transmittance of the shielding base member can be improved rather than the first embodiment in which the PET reflection preventing layer is employed. As a result, the visibility of the PDP can be improved rather than the shielding base member 26b of the first embodiment.

### (Fifth Embodiment)

FIG.7 is a schematic sectional view showing a shielding base member according to a fifth embodiment of the present invention. The shielding base member of the fifth embodiment is formed by replacing the material of the reflection preventing layer in the shielding base member of the third embodiment. Therefore, in FIG.7, the same symbols are affixed to the same elements as those in FIG.5, and their detailed explanation will be omitted herein.

The difference of the shielding base member 26d of the present embodiment from the shielding base member 26b of the third embodiment resides in that, as shown in FIG.7, the TAG film is employed in place of the PET film as the reflection preventing layer. In other words, a first TAC reflection preventing layer 20d to which the reflection preventing function is provided by forming the reflection preventing layer on the TAC film, or the like is formed on the surface of the glass substrate 10 on the PDP operator side, and a second TAG reflection preventing layer 20e is similarly formed on the surface of the glass substrate 10 on the PDP side.

Also, at least one reflection preventing layer of the first TAG reflection preventing layer 20d and the second TAG reflection preventing layer 20e has the ultraviolet (UV) absorbing function. In addition, none of the first, second, third and fourth adhesive layers 12c, 12d, 12e, 12f has the ultraviolet (UV) absorbing function.

Also, at least one adhesive layer of the first, second, third and fourth adhesive layers 12c, 12d, 12e, 12f has the color correcting function. It is preferable that the second adhesive layer 12d should have the color correcting function. In this case, the black frame layer 22 may be omitted herein.

According to the shielding base member 26d of the present embodiment, the first and second TAG reflection preventing layers 20d, 20e can improve the optical transmittance in contrast to the PET reflection preventing layer. Therefore, the visibility of the PDP can be improved rather than the shielding base member 26b of the third embodiment.

### (Sixth Embodiment)

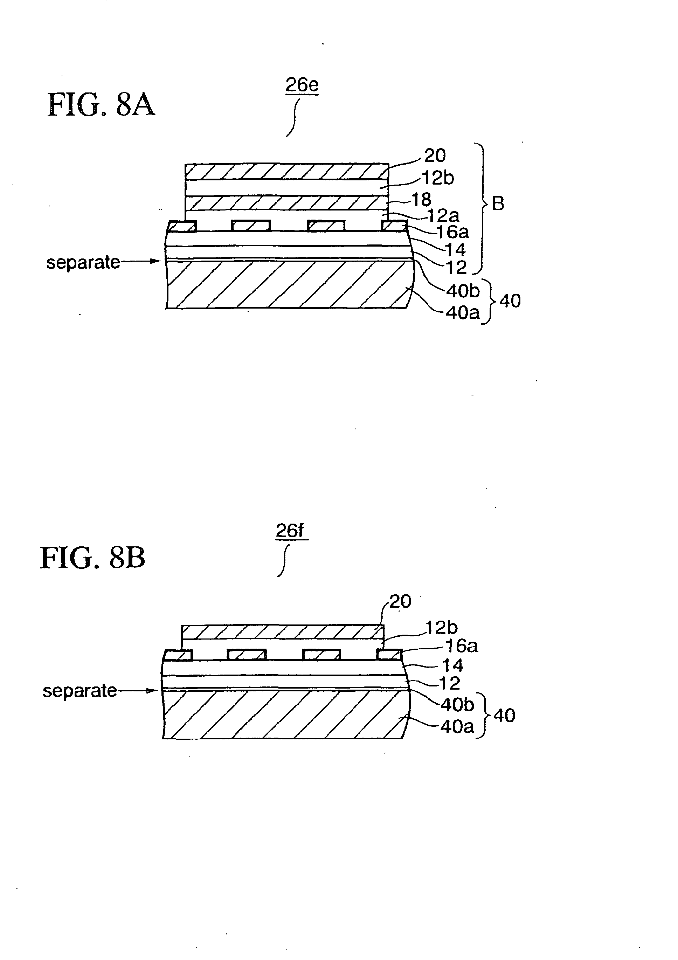

FIG.8A and FIG.8B are schematic sectional views showing a shielding base member according to a sixth embodiment of the present invention respectively. Unlike the shielding base members of the first and second embodiments, the shielding base member of the sixth embodiment employs not the glass substrate as the transparent substrate but the separator that has the release layer on its surface. Therefore, in FIG.8A and FIG.8B, the same symbols are affixed to the same elements as those in FIG.3A, and their detailed explanation will be omitted herein.

As shown in FIG.8A, the transparent substrate of the shielding base member 26e of the present embodiment is formed of a separator 40. This separator 40 consists of a silicone layer 40b and a PET film 40a.

When this shielding base member 26e is fitted to the display screen of the PDP, the silicone layer 40b is separated along the interface between the silicone layer 40b and the first adhesive layer 12 and then an exposed surface of the first adhesive layer 12 of a structural body B in the shielding base member except the separator 40 is pasted directly onto the display screen of the PDP, whereby it is possible to cause the structural body B to function as the shielding base member of the PDP.

When this shielding base member 26e of the present embodiment is fitted to the display screen of the PDP, the PET film 40a does not remain. Therefore, the shielding base member that has the high optical transmittance and the low haze (degree of the opaque) can be obtained.

Also, since the use of the glass substrate is not needed, the structure of the shielding base member can be made simple. Thus, not only the shielding base member of the present embodiment can be manufactured easily but also the production cost thereof can be reduced.

The reflection preventing layer 20 may be formed of either the PET reflection preventing layer or the TAC reflection preventing layer. If the PET reflection preventing layer is employed, the third adhesive layer 12b, for example, may have the ultraviolet (UV) absorbing function, like the first embodiment. If the TAG reflection preventing layer is employed, the TAC reflection preventing layer 20 itself may have the ultraviolet (UV) absorbing function, like the fourth embodiment. Also, like the first embodiment, at least one adhesive layer may have the color correcting function.

A shielding base member shown in FIG.8B is a variation of the shielding base member 26e shown in FIG.8A. The second adhesive layer 12a and the near-infrared absorbing layer 18 of the shielding base member 26e shown in FIG.8A are omitted. In this variation, like the second embodiment; at least one of the first adhesive layer 12 and the third adhesive layer 12b may have the near-infrared absorbing function.

Next, the manufacturing method of the shielding base member 26e of the sixth embodiment will be explained hereunder.

First, according to the similar method to the first embodiment, the roll-like separator 40 formed of the PET film 40a on one surface of which the silicone layer 40b is coated is prepared, then the separator 40 is extended, then the copper foil 16 is pasted onto the separator 40 via the first adhesive layer 12 and the resin layer 14, and then the copper layer patterns 16a are formed by patterning the copper foil 16 by virtue of the roll-to-roll method.

Then, the near-infrared absorbing layer 18 is formed on the copper layer patterns 16a and the resin layer 14 via the second adhesive layer 12a by the roll-to-roll method. Then, the PET or TAC reflection preventing layer 20 is formed on the near-infrared absorbing layer 18 via the third adhesive layer 12b.

In this case, like the variations of the first and fourth embodiments, instead of the near-infrared absorbing layer 18, the third adhesive layer 12b, and the reflection preventing layer 20, the surface of the PET or TAG film, which has the reflection preventing layer on one surface and has the near-infrared absorbing layer on the other surface, on the near-infrared absorbing layer side may be pasted onto the second adhesive layer 12a over the separator 40.

### (Seventh Embodiment)

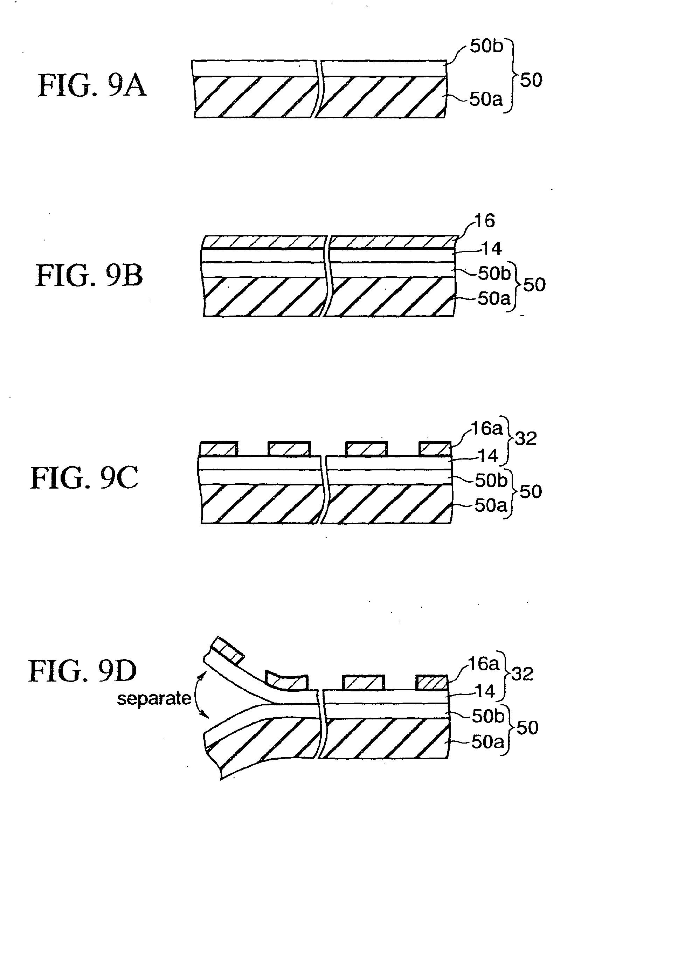

FIG.9A to FIG.9G are schematic sectional views showing a shielding base member manufacturing method according to a seventh embodiment of the present invention. The seventh embodiment intends not to leave the dent defect in the adhesive layer, which is left finally in the shielding base member, by replacing the adhesive layer of the shielding base member with a new adhesive layer in the course of the manufacturing steps. In this case, detailed explanation of the steps similar to the manufacturing method of the first embodiment will be omitted hereunder.

In the shielding base member manufacturing method according to the seventh embodiment, as shown in FIG.9A, first a first PET film 50a that has a temporary adhesive layer 50b having a thickness of about 25 µm, for example, on one surface is prepared as a first protect film 50.

Then, the copper foil 16 (metal foil) whose thickness is about 10 µm, for example, is prepared. Then, the bright surface of the copper foil 16 is subjected to the blackening process by executing the electrolytic plating in the same way as the first embodiment.

Then, as shown in FIG.9B, the resin layer 14 is formed on the temporary adhesive layer 50b of the first protect film 50. Then, the copper foil 16 is arranged such that the blackened surface of the copper foil 16 is directed to the resin layer 14 side, and then pasted onto the resin layer 14 by applying the pressure to the copper foil 16 by virtue of the same method as the first embodiment.

Accordingly, a structure in which the resin layer 14 and the copper foil 16 are laminated sequentially from the bottom on the first protect film 50 is formed. Since the copper foil 16 is pasted onto the first protect film 50, which has the temporary adhesive layer 50b and has the rigidity, via the resin layer 14, the handling of the copper foil 16 can be facilitated.

Then, as shown in FIG.9C, the first protect film 50 is carried by the roll-to-roll method, then resist patterns (not shown) are formed on the copper foil 16, and then the copper foil 16 is etched by spraying the iron (III) chloride aqueous solution, or the like onto the copper foil 16 in the similar way to the first embodiment while using the resist patterns as a mask to form the copper layer patterns 16a (patterns of the metal layer) like the mesh, for example.

At this time, since the copper foil 16 is pasted onto the first protect film 50 having the rigidity, such copper foil 16 can stand the pressure of the sprayed etchant and thus the copper foil 16 can be etched stably.

Then, the exposed surface of the copper layer patterns 16a is subjected to the blackening process by applying the transforming process to the copper layer patterns 16a by using the mixed solution consisting of the chlorite soda aqueous solution and the caustic soda aqueous solution. Since the surface of the copper foil 16 on the resin layer 14 side has already been blackened by the above steps, both surfaces and the side surfaces of the copper layer patterns 16a are subjected completely to the blackening process, as shown in FIG.9C, at a point of time when this step is ended.

In this manner, as shown in FIG.9C, the first transfer body 32 consisting of the resin layer 14 and the copper layer patterns 16a is formed on the first protect film 50.

In the above step of forming the copper layer patterns 16a, etc., the roll-to-roll method is employed. Therefore, if the temporary adhesive layer 50b is pushed by the mixed foreign matter when a portion of the first protect film 50, in which the etching of the copper foil 16 is completed, is wound on the roll, or the like, the dent defect is ready to occur in the temporary adhesive layer 50b because the temporary adhesive layer 50b itself is soft.

However, in the shielding base member manufacturing method of the present embodiment, as described later, the temporary adhesive layer 50b is replaced with another new first adhesive layer. Therefore, there is no problem even if the dent defect is generated in the temporary adhesive layer 50b. In this case, the temporary adhesive layer is also called the first adhesive layer, and the first adhesive layer is also called the second adhesive layer.

Then, as shown in FIG.9D, the first transfer body 32 consisting of the resin layer 14 and the copper layer patterns 16a is obtained by cutting the first protect film 50 into a predetermined dimension and then separating the temporary adhesive layer 50b from the resin layer 14. At this time, the first protect film 50 having the temporary adhesive layer 50b in which the dent defect occurs is abandoned.

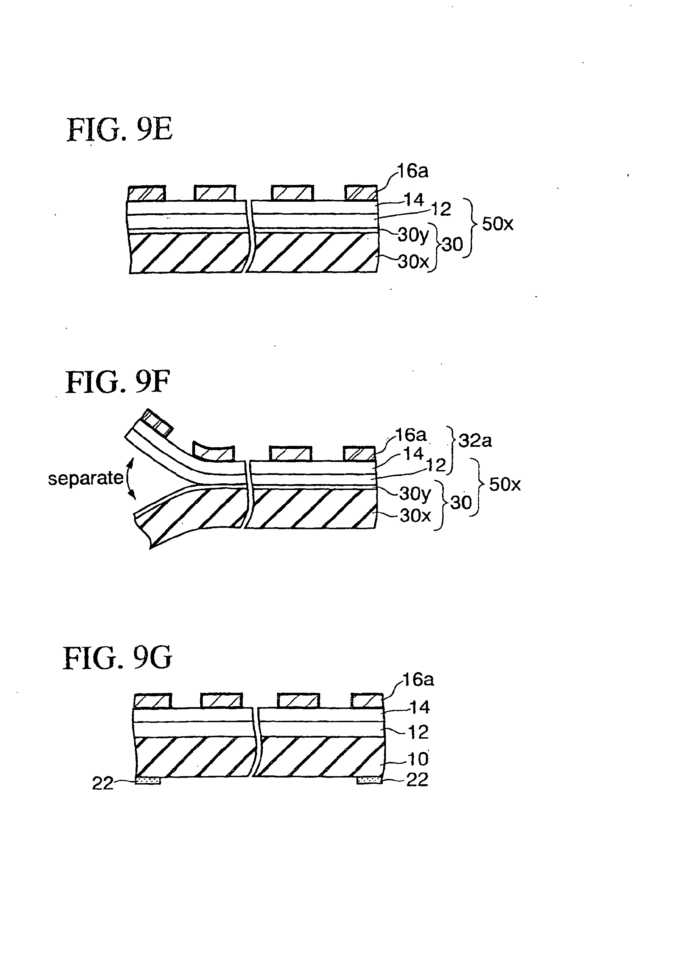

Then, as shown in FIG.9E, a second PET film 30x, on one surface of which a silicone layer 30y (release layer) of about 1 µm thickness is coated and which has a predetermined dimension, is prepared. The silicone layer 30y is formed by the same method as the first embodiment. This second PET film 30x on one surface of which the silicone layer 30y is formed is called the separator 30 hereinafter.

Then, as shown in FIG.9E similarly, a second protect film 50x consisting of the separator 30 and the first adhesive layer 12 is formed by forming the first adhesive layer 12 of about 25 µm thickness on the silicone layer 30y of the separator 30. Then, the resin layer 14 and the copper layer patterns 16a are formed on the first adhesive layer 12 of the second protect film 50x by pasting the surface of the first adhesive layer 12 of the second protect film 50x onto the surface of the resin layer 14 of the above transfer body 32.

Accordingly, the first adhesive layer 12 is formed under the resin layer 14 instead of the above temporary adhesive layer 50b. In other words, even when the dent defect is generated in the temporary adhesive layer 50b, such temporary adhesive layer 50b is replaced with the new first adhesive layer 12 that contains no dent defect. Then, since there is no need to employ the roll-to-roll method in the step executed after the step of forming the first adhesive layer 12 on the second protect film 50x, the first adhesive layer 12 is not wound onto the roll. Therefore, there is no possibility that the dent defect due to the foreign matter, or the like occurs newly in the first adhesive layer 12. As a result, the first adhesive layer 12 that is left finally in the shielding base member has no dent defect.

Then, as shown in FIG.9F, the separator 30 is removed from the structural body in FIG.9F by separating the silicone layer 30y (release layer) of the separator 30 from the first adhesive layer 12 along the interface between them. Thus, the second transfer body 32a that consists of the first adhesive layer 12, the resin layer 14, and the copper layer patterns 16a sequentially from the bottom is obtained.

Then, as shown in FIG.9G, the transparent glass substrate 10 (transparent substrate), on a predetermined peripheral portion of one surface of which the black frame layer 22 is formed and which has a predetermined dimension, is prepared. Then, the surface of the first adhesive layer 12 of the transfer body 32a is pasted onto the surface of the glass substrate 10, on which the black frame layer 22 is not formed. Accordingly, the first adhesive layer 12 in which no dent defect is generated, the resin layer 14, and the copper layer patterns 16a are formed sequentially from the bottom on the glass substrate 10.

Then, as shown in FIG.3A (first embodiment), the second adhesive layer 12a having the color correcting function is formed on the copper layer patterns 16a and the resin layer 14 by the same method as the first embodiment to expose the copper layer patterns 16a on the predetermined peripheral portion of the glass substrate 10. Then, the near-infrared absorbing layer 18 is formed on this second adhesive layer 12a.

Then, the third adhesive layer 12b having the ultraviolet (UV) absorbing function is formed on the near-infrared absorbing layer 18. And then a PET reflection preventing layer 20 having reflection preventing function is formed on the third adhesive layer 12b by using a PET film that a reflection preventing layer is formed on a one surface thereof, or the like or the like.

In this manner, the same shielding base member as the shielding base member 26 shown in FIG.3A can be obtained by the shielding base member manufacturing method according to the seventh embodiment.

As described above, the shielding base member manufacturing method of the present embodiment is provided to prevent the situations that the PET film (except the PET reflection preventing layer 20), whose optical transmittance is low and whose haze (degree of opaque) is high, is not left in the shielding base member 26 and also the dent defect is not left in the adhesive that is finally left in the shielding base member.

More particularly, first the resin layer 14 and the copper foil 16 are formed on the first protect film 50, and then the copper layer patterns 16a are formed by patterning the copper foil 16. At this time, since the roll-to-roll method is employed for the purpose of improving the production efficiency, the dent defect easily occurs in the temporary adhesive layer 50b. Then, in order to remove the temporary adhesive layer 50b in which the dent defect occurs, the temporary adhesive layer 50b of the first protect film 50 is separated from the resin layer 14 along the interface. Thus, the first transfer body 32 consisting of the resin layer 14 and the copper layer patterns 16a formed thereon is obtained.

Then, the second protect film 50x is obtained by forming the first adhesive layer 12 on the silicone layer 30y (release layer) of the separator 30. Then, the surface of the resin layer 14, on which the copper layer patterns 16a are not formed, in the above first transfer body 32 is pasted onto the surface of the first adhesive layer 12 of the second protect film 50x. Accordingly, the new first adhesive layer 12 in which the dent defect is not generated is formed under the resin layer 14.

Then, the second transfer body 32a consisting of the first adhesive layer 12, the resin layer 14, and the copper layer patterns 16a is obtained by separating the first adhesive layer 12 from the silicone layer 30y (release layer) of the separator 30 along the interface. Then, the exposed surface of the first adhesive layer 12 of this second transfer body 32a is pasted onto one surface of the glass substrate 10. Thus, the first adhesive layer 12 that contains no dent defect, the resin layer 14, and the copper layer patterns 16a are formed on the glass substrate 10 sequentially from the bottom.

As described above, according to the shielding base member manufacturing method according to the present embodiment, since the PET films 50a, 30x do not remain in the shielding base member, the shielding base member whose optical transmittance is high and whose haze (degree of opaque) is low can be obtained. Also, since the copper foil 16 is formed on the first protect film 50 having the rigidity, such copper foil 16 can be patterned by the roll-to-roll method while expanding the roll-like first protect film 50, and thus the production efficiency can be improved.

In addition, even if the dent defect occurs in the temporary adhesive layer 50b at this time, no dent defect exists in the first adhesive layer 12 of the shielding base member because the temporary adhesive layer 50b can be replaced with the new first adhesive layer 12. Therefore, the shielding base member of the high quality can be manufactured.

### (Eighth Embodiment)

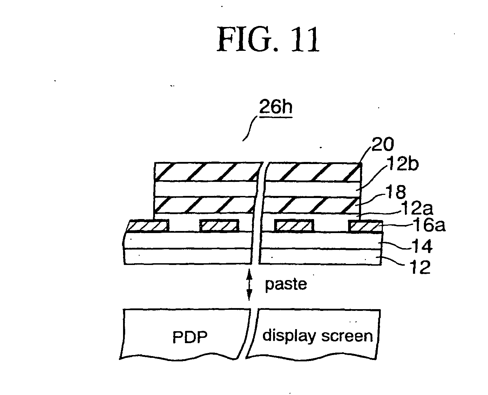

FIG.10A to FIG.10C are schematic sectional views showing a shielding base member manufacturing method according to an eighth embodiment of the present invention, and FIG.11 is a schematic sectional view showing a shielding base member according to the eighth embodiment of the present invention. The different point of the shielding base member manufacturing method of the eighth embodiment from the sixth embodiment resides in that the second transfer body consisting of the first adhesive layer, the resin layer, and the copper layer patterns, which are manufactured based on the manufacturing method of the seventh embodiment, or the like is pasted directly onto the display screen of the PDP to employ as the shielding base member.

In the shielding base member manufacturing method of the eighth embodiment, as shown in FIG.10A, first the same structure as that shown in FIG.9E in the seventh embodiment is formed. That is, the structure in which the first adhesive layer 12 that contains no dent defect, the resin layer 14, and the copper layer patterns 16a are formed on the second protect film 50x is formed.

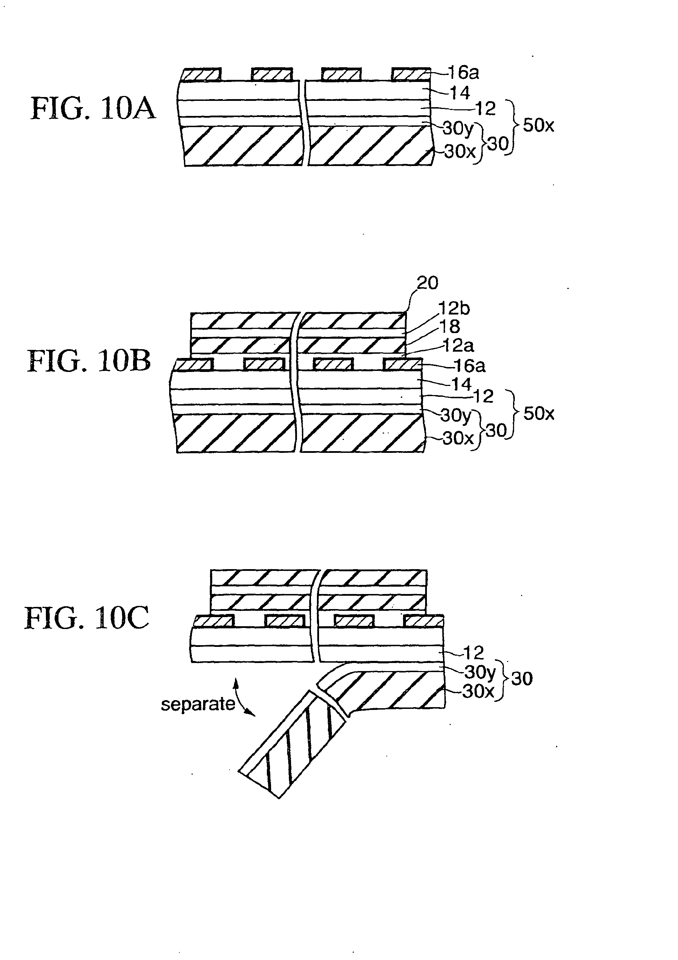

Then, the second protect film 50x is cut into a predetermined size. Then, as shown in FIG.10B, the second adhesive layer 12a is formed on the copper layer patterns 16a and the resin layer 14 to expose the copper layer patterns 16a on the predetermined peripheral portion. Then, the near-infrared absorbing layer 18 is formed on the second adhesive layer 12a.

Then, the third adhesive layer 12b is formed on the near-infrared absorbing layer 18, and then the PET reflection preventing layer 20 is formed on the third adhesive layer 12b.

Then, as shown in FIG.10C, the separator 30 is removed from the structural body in FIG.10B by separating the silicone layer 30y (release layer) of the separator 30 from the first adhesive layer 12 along the interface.

Accordingly, as shown in FIG.11, a shielding base member 26h consisting of the first adhesive layer 12 that contains no dent defect, the resin layer 14, the copper layer patterns 16a, the second adhesive layer 12a, the near-infrared absorbing layer 18, the third adhesive layer 12b, and the PET reflection preventing layer 20 sequentially from the bottom is obtained. In this case, it is of course that the shielding base member may be constructed by omitting the near-infrared absorbing layer 18, the PET reflection preventing layer 20, etc.

Then, as shown in FIG.11, the PDP shielding base member is obtained by pasting directly the exposed surface of the first adhesive layer 12 of the shielding base member 26h onto the display screen of the PDP.

According to the shielding base member manufacturing method the present embodiment, since the PET film does not remain in the shielding base member 26h like the first embodiment, the shielding base member whose optical transmittance is high and whose haze (degree of opaque) is low can be easily manufactured. Also, since the first adhesive layer 12 having no dent defect remains in the shielding base member 26h, the shielding base member of the high quality can be manufactured.

In this case, like the variation (the structure in FIG.3B) of the first embodiment, the PET film 21, on the other surface of which the near-infrared absorbing layer 23 is formed and on the other surface of which the reflection preventing layer 25 is formed, may be pasted onto the second adhesive layer 12a. Also, like the second embodiment, the near-infrared absorbing layer may not be particularly formed and the near-infrared absorbing function may be provided to the adhesive layer.

In addition, the TAC reflection preventing layer may be employed in place of the PET reflection preventing layer 20. The third adhesive layer 12b, for example, may have the ultraviolet (UV) absorbing function, like the first embodiment, if the PET reflection preventing layer is employed, whereas the TAC reflection preventing layer itself may have the ultraviolet (UV) absorbing function, like the fourth embodiment, if the TAG reflection preventing layer is employed. Also, like the first embodiment, at least one adhesive layer of the first, second, and third adhesive layers 12, 12a, 12b may have the color correcting function.

With the above, the shielding base member 26h of the eighth embodiment can be manufactured.

### (Ninth Embodiment)

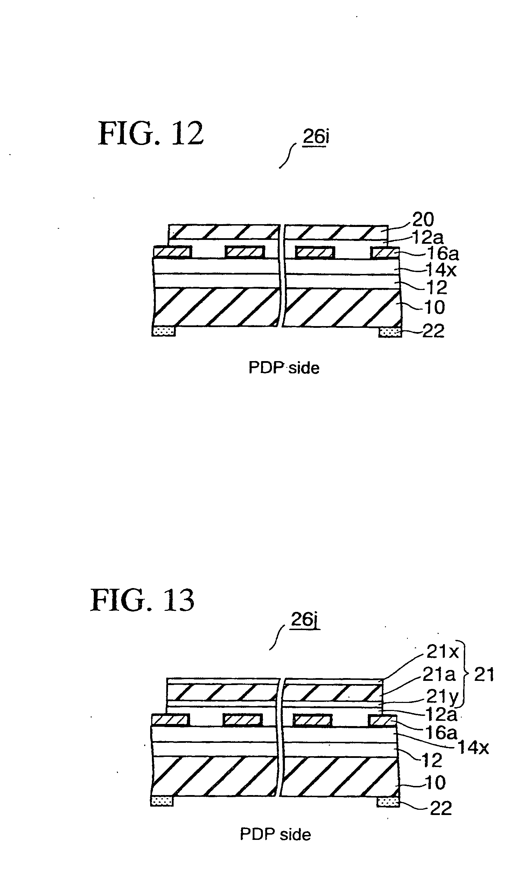

FIG.12 is a schematic sectional view showing a shielding base member according to a ninth embodiment of the present invention, and FIG.13 is a schematic sectional view showing a variation of the shielding base member according to the ninth embodiment of the present invention. In FIG.12 and FIG.13, the same symbols are affixed to the same elements as those in FIG.3A and others, and their detailed explanation will be omitted herein.

The different point of the shielding base member of the ninth embodiment from other embodiments is that, as shown in FIG.12, the plastic film having the near-infrared absorbing function is not pasted as the near-infrared absorbing layer but the near-infrared absorbing function is provided to a resin layer 14x.

The shielding base member of the ninth embodiment is manufactured by the same method as the manufacturing methods in the first and seventh embodiments except the resin layer forming step. Therefore, the step of forming the resin layer 14x having the near-infrared absorbing function on the first adhesive layer 12 will be explained hereunder.

First, a coating liquid is formed as the near-infrared absorber by stirring a mixed solution in which pigment material (Tx-EX811K manufactured by Nippon Shokubai Co., Ltd.), acrylic resin (Dianal BR-80 manufactured by Mitsubishi Rayon Co., Ltd.), toluene, and methyl ethyl ketone are mixed at rates of 1 wt%, 2 wt%, 3 wt%, and 3 wt% respectively.

Then, this coating liquid is coated on the first adhesive layer 12 by the roll coating method, or the like, and then this first adhesive layer 12 is left as it is in the atmosphere of about 50 °C for 48 hours, for example. Accordingly, the resin layer 14x having the near-infrared absorbing function is formed on the first adhesive layer 12. The resin layer 14x obtained in this manner can absorb the spectrum near 820 nm that is emitted from the PDP.

Otherwise, first a coating liquid is formed as the near-infrared absorber by stirring a mixed solution in which pigment material (Kayasorb IRG-022 manufactured by Nippon Kayaku Co., Ltd.), copolymer polyester resin, methyl ethyl ketone, and toluene are mixed at rates of 1 wt%, 2 wt%, 3 wt%, and 3 wt% respectively. Then, this coating liquid is coated on the first adhesive layer 12 by the roll coating method, or the like, and then the resin layer 14x having the near-infrared absorbing function may be formed by leaving this first adhesive layer 12 as it is in the atmosphere of about 50 °C for 48 hours, for example. The resin layer 14x obtained in this manner can absorb the spectrum of 850 to 1200 nm that is emitted from the PDP.

In this case, since the maximum absorption wavelength is different according to the color tone of the pigment material, the types of the pigment material can be adjusted appropriately to meet the characteristic of the shielding base member. For example, one type of pigment material may be employed, or plural different pigment materials may be employed to absorb the light in the wide area of the near-infrared range. It is preferable that at least the pigment material having the maximum absorption wavelengths such as 820 nm, 880 nm, 980 nm, etc., which are used particularly in the remote control unit or the optical communication, in the near-infrared range should be contained.

It is preferable that plural pigment materials should be contained in the resin layer 14x so as to absorb the near-infrared ray in the predetermined wavelength range. In this case, if the resin layer 14x contains a plurality of pigment materials, the case where the durability becomes worse by the catalytic effect, etc. is considered. That is, in some case the change of the optical characteristics such as the near-infrared shielding characteristic, the color, etc. of the resin layer 14x is caused with the lapse of time.

Therefore, if one type or several types of pigment materials are included in the resin layer 14x and also the pigment materials, which can absorb the near-infrared ray of the wavelength that cannot be absorbed by the resin layer 14x, are included in the second adhesive layer 12a or the PET reflection preventing layer 20, the near-infrared ray may be absorbed in the wide wavelength range.

For example, if the above resin layer 14x that can absorb the spectrum near 820 nm is employed, the pigment material that can absorb the spectrum of 850 to 1200 nm may be included in the second adhesive layer 12a or the PET reflection preventing layer 20. Also, if the above resin layer 14x that can absorb the spectrum of 850 to 1200 nm is employed, the pigment material that can absorb the spectrum near 820 nm may be included in the second adhesive layer 12a or the PET reflection preventing layer 20.

In addition, the color correcting function for correcting the transmission color, the object color, etc. may be provided by including the pigment, which can absorb the wavelength in the visible range, in the resin layer 14x. For instance, the mixed gas consisting of the xenon and the neon is employed in the discharging in the color PDP, and the light emission of the neon in the orange color acts as one factor to lower the color display performance of the PDP. For this reason, the color correction in the color display of the PDP can be executed by including the pigment material, which can suppress the light emission of the neon, for example, in the resin layer 14x.

In this manner, in the shielding base member 26i of the present embodiment, the plastic film having the near-infrared absorbing function is not particularly employed and the near-infrared absorbing function is provided to the resin layer 14x itself. Therefore, the structure of the shielding base member 26i can be made simple. Also, since the plastic film serving as the near-infrared absorbing layer is not left, the optical transmittance becomes high and the haze (degree of opaque) becomes low, and thus the display characteristic of the PDP can be further improved.

Next, a variation of the shielding base member of the present embodiment will be explained hereunder. According to the variation of the shielding base member of the present embodiment, if only one type or several types of pigment materials are added to improve the durability of the resin layer 14x, the near-infrared ray having other wavelengths that cannot be absorbed by the resin layer 14x is shielded by the multi-layered film that cuts off the near-infrared ray by utilizing the reflection characteristic (optical interference) of the light.

First, as shown in FIG.13, a structural body in which the first adhesive layer 12, the resin layer 14x for absorbing the light having the particular wavelength, and the copper layer patterns 16a are formed on the glass substrate 10 by the manufacturing method of the first or seventh embodiment is prepared. Then, as also shown in FIG.13, a highly transparent polyester film 21a is prepared. Then, a multi-layered film 21y is formed by laminating a metal oxide thin film such as zinc oxide, indium oxide, or the like and a metal thin film such as silver, silver alloy, or the like on one surface of the film 21a by the sputter method or the like. For example, a multi-layered film 21 may be formed by repeating almost three to six times the formation of a film consisting of a metal oxide thin film/a metal thin film. Then, a multi-layered film 21 is obtained by forming a reflection preventing layer 21x on the other surface of the highly transparent polyester film 21a.

Otherwise, instead of the formation of the multi-layered film 21y on the highly transparent polyester film 21a, the film to which the near-infrared shielding function is provided by laminating the highly transparent resin films each having a different refractive index is prepared, and then the multi-layered film 21 may be formed by forming the reflection preventing layer 21x on this film.

The multi-layered film 21 formed in this manner can reflect the light in the predetermined near-infrared range by utilizing the light reflection characteristic (optical interference) of the multi-layered film 21y to shield the light and also have the light reflection preventing function.

Then, as also shown in FIG.13, the second adhesive layer 12a is formed on the copper layer patterns 16a and the resin layer 14x, and then the surface of the multi-layered film 21 on the multi-layered film 21y side is pasted onto the glass substrate 10 via the second adhesive layer 12a. Accordingly, the multi-layered film 21 having the multi-layered film 21y and the reflection preventing layer 21x is formed on the second adhesive layer 12a. With the above, the shielding base member 26j of the variation of the present embodiment is completed.

In the shielding base member 26j of the variation of the present embodiment, since the shielding base member having the substantially same functions as the above shielding base member 26i can be obtained, the similar effects can be achieved. Also, since the highly transparent polyester film is used as the plastic film, the optical transmittance of the shielding base member can be increased and also the haze (degree of opaque) can be reduced.

The details of the present invention are explained as above with reference to the first to ninth embodiments. However, the scope of the present invention is not limited to the examples being given particularly in the above embodiments, and variations of the above embodiments in the range of gist not to depart from the present invention are contained in the scope of the present invention.

## Claims

1. A shielding base member manufacturing method comprising the steps of:
forming a structure, in which a first adhesive layer (12), a resin layer (14), and a metal foil (16) are laminated sequentially from a bottom, on a release layer (30b) of a plastic film (30a) that has the release layer (30b) on a surface;
forming metal layer patterns (16a) by patterning the metal foil (16); and
forming the first adhesive layer (12), the resin layer (14), and the metal layer patterns (16a) sequentially from the bottom on a transparent substrate (10) by separating the release layer (30b) from the first adhesive layer (12) along an interface and then pasting the first adhesive layer (12) onto the transparent substrate (10).

2. A shielding base member manufacturing method comprising the steps of:
forming a structure, in which a first adhesive layer (12), a resin layer (14), and a metal foil (16) are laminated sequentially from a bottom, on a release layer (30b) of a plastic film (30a) that has the release layer (30b) on a surface;
forming the first adhesive layer (12), the resin layer (14), and the metal foil (16) sequentially from the bottom on a transparent substrate (10) by separating the release layer (30b) from the first adhesive layer (12) along an interface and then pasting the first adhesive layer (12) onto the transparent substrate (10); and
forming metal layer patterns (16a) by patterning the metal foil (16).

3. A shielding base member manufacturing method according to claim 1, wherein the step of forming the structure, in which the first adhesive layer (12), the resin layer (14), and the metal foil (16) are laminated, includes the step of applying a blackening process to a surface of the metal foil (16) on a resin layer (12) side.

4. A shielding base member manufacturing method according to claim 1, further comprising the step of:
applying a blackening process to an exposed surface of the metal layer patterns (16a) after the step of forming the metal layer patterns (16a).

5. The shielding base member manufacturing method according to claim 1, further comprising the step of:
forming a reflection preventing layer (20) on the metal layer patterns (16a) and the resin layer (14) via a third adhesive layer (12b) after the step of forming the metal layer patterns (16a).

6. The shielding base member manufacturing method according to claim 5, further comprising the step of:
forming a near-infrared absorbing layer (18) on the metal layer patterns (16a) and the resin layer (14) via a second adhesive layer (12a) before the step of forming the reflection preventing layer(20)

7. A shielding base member manufacturing method comprising the steps of:
preparing a first plastic film (50a) including a first adhesive layer (50b), a resin layer (14), and a metal foil (16) sequentially from a bottom on a surface;
forming metal layer patterns (16a) by patterning the metal foil (16);
forming the resin layer (14) and the metal layer patterns (16a) on a second adhesive layer (12) of a second plastic film (30x), which has a release layer (30y) and the second adhesive layer (12) sequentially from the bottom on a surface, by separating the first adhesive layer (50b) from the resin layer (14) along an interface and then pasting a surface of the second adhesive layer (12) of the second plastic film (30x) onto a surface of the resin layer (14); and
forming the second adhesive layer (12), the resin layer (14), and the metal layer patterns (16a) sequentially from the bottom on a transparent substrate (10) by separating the release layer (30y) from the second adhesive layer (12) along an interface and then pasting a surface of the second adhesive layer (12) onto the transparent substrate (10).

8. A shielding base member manufacturing method comprising the steps of:
preparing a first plastic film (50a) including a first adhesive layer (50b), a resin layer (14), and a metal foil (16) sequentially from a bottom on a surface;
forming metal layer patterns (16a) by patterning the metal foil (16);
forming the resin layer (14) and the metal layer patterns (16a) on a second adhesive layer (12) of a second plastic film(30x), which has a release layer (30y) and the second adhesive layer (12) sequentially from the bottom on a surface, by separating the first adhesive layer (50b) from the resin layer (14) along an interface and then pasting a surface of the second adhesive layer (12) of the second plastic film (30x) onto a surface of the resin layer (14); and
getting a shielding base member including the second adhesive layer (12), the resin layer (14), and the metal layer patterns (16) by separating the release layer (30y) from the second adhesive layer (12) along an interface.

9. The shielding base member manufacturing method according to claim 8, wherein a surface of the second adhesive layer (12) the shielding base member is pasted onto a display screen of a PDP (plasma display panel) after the step of getting the shielding base member.

10. The shielding base member manufacturing method according to claim 7, wherein the step of preparing the first plastic film (50a) includes the step of applying a blackening process to a surface of the metal foil (16) on a resin layer (14) side.

11. The shielding base member manufacturing method according to claim 10, further comprising the step of:
applying a blackening process to an exposed surface of the metal layer patterns (16a) after the step of forming the metal layer patterns (16a) by patterning the metal foil (16) and before the step of forming the resin layer (14) and the metal layer patterns (16a) on the second adhesive layer (12)of the second plastic film (30x).

12. The shielding base member manufacturing method according to claim 7, further comprising the step of:
forming a reflection preventing layer on the metal layer patterns (16a) and the resin layer (14) via a fourth adhesive layer (12b) after the step of forming the second adhesive layer (12), the resin layer (14), and the metal layer patterns (16a) sequentially from the bottom on the transparent substrate (10).

13. The shielding base member manufacturing method according to claim 12, further comprising the step of:
forming a near-infrared absorbing layer (18) on the metal layer patterns (16a) and resin layer (14) via a third adhesive layer (12a) after the step of forming the second adhesive layer (12), the resin layer (14), and the metal layer patterns (16a) sequentially from the bottom on the transparent substrate (10) and before the step of forming the reflection preventing layer (20).

14. The shielding base member manufacturing method according to claim 8, further comprising the step of:
forming a reflection preventing layer (20) on the metal layer patterns (16a) and the resin layer (14) via a fourth adhesive layer (12b) after the step of forming the resin layer and the metal layer patterns (16a) on the second adhesive layer (12) of the second plastic film (30x) and before the step of getting the shielding base member.

15. The shielding base member manufacturing method according to claim 14, further comprising the step of:
forming a near-infrared absorbing layer (18) on the metal layer patterns (16a) and resin layer (14) via a third adhesive layer (12a) after the step of forming the resin layer (14) and the metal layer patterns (16a) on the second adhesive layer (12) of the second plastic film (30x) and before the step of forming the reflection preventing layer (20).

16. A shielding base member comprising:
a transparent substrate (10);
a first adhesive layer (12) formed on the transparent substrate (10);
a resin layer (14) formed on the first adhesive layer (12);
metal layer patterns (16a) formed on the resin layer (14); and
a reflection preventing layer (20) formed on the metal layer patterns (16a) and the resin layer (14) via a third adhesive layer (12b).

17. The shielding base member according to claim 16, further comprising:
a plastic film (21) on one surface of which the reflection preventing layer (25)is formed; and
a near-infrared absorbing layer (23) formed on another surface of the plastic film (21);
wherein the third adhesive layer (12a) formed over the transparent substrate (10) is pasted onto the near-infrared absorbing layer (23) formed on another surface of the plastic film (21).

18. The shielding base member according to claim 16, wherein surfaces of the metal layer patterns (16a) on a resin layer (14) side and a surface and side surfaces of the reflection preventing layer (20) are black-ized.

19. The shielding base member according to claim 16, wherein at least one adhesive layer of the first adhesive layer (12) and the third adhesive layer (12b) has a near-infrared absorbing function.

20. The shielding base member according to claim 16, further comprising:
a near-infrared absorbing layer (18) formed on the metal layer patterns (16a) and the resin layer (14) via a second adhesive layer (12a) and between the metal layer patterns (16a) and the third adhesive layer (12b).

21. The shielding base member according to claim 16, wherein the reflection preventing layer (20) is formed on a PET (polyethylene terephthalate) film, and at least one adhesive layer of adhesive layers (12,12b) has a ultraviolet (UV) absorbing function.

22. The shielding base member according to claim 16, wherein the reflection preventing layer (20) is formed on a TAC (triacetylcellulose) film and has a ultraviolet (UV) absorbing function.

23. The shielding base member according to claim 16, wherein at least one adhesive layer of adhesive layers (12,12b) has a color correcting function.

24. The shielding base member according to claim 16, wherein the transparent substrate (10) is formed of glass.

25. The shielding base member according to claim 16, wherein the transparent substrate is a separator (30) that has a release layer (30y) on a surface of the first adhesive layer (12), and the separator (30) is separated from the shielding base member and a layer except the separator (30) is pasted onto a display screen of PDP via the first adhesive layer (12).

26. A shielding base member comprising:
a transparent substrate (10);
a first adhesive layer (12) formed on the transparent substrate (10);
a resin layer (14x) formed on the first adhesive layer (12) and having at least a near-infrared absorbing function;
metal layer patterns (16a) formed on the resin layer (14x); and
a filter layer (20) formed on the metal layer patterns (16a) and the resin layer (14x) via a second adhesive layer (12a) and having at least a reflection preventing function.

27. The shielding base member according to claim 26, wherein the resin layer (14x) includes a pigment material that absorbs a near-infrared ray having a predetermined wavelength.

28. The shielding base member according to claim 26, wherein the resin layer (14x) has further a color correcting function.

29. The shielding base member according to claim 27, wherein the filter layer (20) has further a function of absorbing the near-infrared ray having a different wavelength from a wavelength of the near-infrared ray, which is absorbed by the resin layer (14x).

30. The shielding base member according to claim 27, wherein the filter layer (20) includes a plastic film (21a), a reflection preventing layer (21x) formed on one surface of the plastic film (21a), and a near-infrared absorbing layer (21y) formed on another surface of the plastic film (21a).

31. The shielding base member according to claim 27, wherein the filter layer (20) includes f a plastic film (21a), a reflection preventing layer (21x) formed on one surface of the plastic film (21a), and a near-infrared shielding layer (21y) formed on another surface of the plastic film (21a) and having a multi-layered structure in which a metal oxide and a metal film are laminated.
